**Europäisches Patentamt**

**European Patent Office**

**Office européen des brevets**

(19)

(11) Veröffentlichungsnummer: **0 163 255 B1**

(12) **EUROPÄISCHE PATENTSCHRIFT**

(45) Veröffentlichungstag der Patentschrift: **27.02.91**

(51) Int. Cl.⁵: **H05K 13/00**

(21) Anmeldenummer: **85106323.0**

(22) Anmeldetag: **23.05.85**

(54) **Vorrichtung zum automatischen Beschicken einer Laminierstation.**

(30) Priorität: 01.06.84 DE 3420426
23.03.85 DE 3510579

(43) Veröffentlichungstag der Anmeldung:
**04.12.85 Patentblatt 85/49**

(45) Bekanntmachung des Hinweises auf die
Patenterteilung:
**27.02.91 Patentblatt 91/09**

(84) Benannte Vertragsstaaten:
**AT BE CH DE FR GB IT LI NL SE**

(56) Entgegenhaltungen:
**EP-A- 0 058 421**
**FR-A- 2 495 121**
**US-A- 3 947 016**
**US-A- 4 214 936**

(73) Patentinhaber: **HOECHST AKTIENGESELL-
SCHAFT**
**Postfach 80 03 20**
**D-6230 Frankfurt am Main 80(DE)**

(72) Erfinder: **Kühnert, Hans-Günter Egbert**
**Lerchenweg 8**
**D-6106 Erzhausen(DE)**

EP 0 163 255 B1

## Beschreibung

Die Erfindung betrifft eine Vorrichtung zum automatischen Beschicken einer Laminierstation mit einem Schichtträger, einer aus zumindest einer Greiferleiste bestehenden Greifereinrichtung, die an zwei Führungsstangen, von denen jede in einer Linearführung geführt ist, horizontal mittels eines Pneumatikzylinders hin- und herfahrbar angeordnet ist, der über eine Stange mit einer Querstrebe der Greifereinrichtung verbunden ist, wobei der Pneumatikzylinder in der Mitte des Abstandes der beiden Führungsstangen voneinander angeordnet ist.

Aus der europäischen Patentanmeldung EP-A 0 058 421 ist eine derartige Vorrichtung zum automatischen Beschicken einer Bearbeitungsstation, mit einer Greifereinrichtung, bekannt, die horizontal hin- und herverfahrbar ist, wobei die Greifereinrichtung an zwei Führungsstangen befestigt ist, von denen jede in einer Linearführung geführt ist und mit einem Pneumatikzylinder, der über eine Stange mit der Greifereinrichtung verbunden ist und diese auf die oder von der Bearbeitungsstation verfährt. Der Pneumatikzylinder mit der Stange ist in der Mitte des Abstandes der beiden Führungsstangen an einer Querstrebe der Greifereinrichtung angelenkt. Die Greiferleisten dieser bekannten Greifervorrichtung erfassen den Schichtträger an seinen Seitenkanten, jedoch nicht quer zu seiner Transportrichtung über die gesamte Schichtträgerbreite.

Aus der europäischen Patentanmeldung 0 084 077 ist eine Vorrichtung zum automatischen Beschicken von Trägerplatten für gedruckte elektrische Schaltungen an eine Filmaufwalzeinrichtung bekannt, bei der über einem Plattenstapel eine Halteeinrichtung vorgesehen ist, die in senkrechter Richtung gegenüber dem Plattenstapel hin- und herbewegbar ist. Die Halteeinrichtung nimmt zwei parallele, waagerechte Führungsstangen auf, die an ihren entgegengesetzten Enden Kolbenzylindereinheiten tragen, deren Kolbenstangen parallele, in einer Horizontalebene angeordnete Querträger aufweisen, an deren freien Enden einstellbare Greifer vorgesehen sind. Die Greifer sind in waagerechter sowie in senkrechter Richtung bewegbar. Parallel zu jedem Querträger ist ein verschiebbarer Rollengang angeordnet, der in einer waagerechten Ebene aus einer Ruhelage in eine Arbeitsstellung und umgekehrt bewegbar ist. In der Arbeitsstellung übergeben die Greifer die Trägerplatten an die Rollengänge.

Trägerplatten für gedruckte Schaltungen werden nach dem Säubern, Waschen und Trocknen einer Laminierstation bzw. einer Filmaufwalzeinrichtung zugeführt, in der auf die Trägerplatte ein Fotoresistfilm auflaminiert wird. Die Trägerplatten sind im allgemeinen gestapelt, und es ist bekannt, daß der Transport der Trägerplatten für gedruckte elektrische Schaltungen vom Stapel zur Laminierstation Schwierigkeiten insofern mit sich bringt, daß die empfindliche Oberfläche der Trägerplatten mechanisch nicht beansprucht werden darf, um Kratzer, Eindrücke oder Abdrücke zu vermeiden. Auch der Einsatz von elastischen Gummisaugern ist problematisch, da entsprechende Abdrücke der Gummisauger auf den Platten verbleiben können, die zu einer Verschmutzung führen können, die das sichere Aufbringen des Fotoresistfilms in der Walzeinrichtung beeinträchtigen könnten. Gemäß der zuvor erwähnten europäischen Patentanmeldung 0 084 077 sollen diese Nachteile im Stand der Technik vermieden werden, indem eine automatische Beschickungsvorrichtung von Trägerplatten für gedruckte Schaltungen an eine Laminierstation geschaffen wird, die mit Greifern arbeitet, welche mit den Oberflächen der Trägerplatten nicht in Kontakt gelangen, sondern nur mit den Längskanten der Trägerplatten.

Im allgemeinen erfolgt der Transport derartiger Trägerplatten, Schichtträger, Multilayerschichten oder sonstiger Platten, die laminiert werden sollen, von einer Heizstation zu der Laminierstation mittels geführter Finger, die an der Hinterkante der zu transportierenden Platte anliegen und diese in Richtung der Laminierstation schieben. Dabei ergeben sich Schwierigkeiten, wenn die Platte infolge ihrer Dünnheit nur geringe Biegesteifigkeit besitzt, da dann diese nicht ausreicht, ein sicheres Einführen der Vorderkante der Platte in den Spalt zwischen den Laminierwalzen der Laminierstation zu gewährleisten. Dadurch kann es zu fehlerhaftem Einzug der Platte in die Laminierstation kommen und zu einer dadurch bedingten Beschädigung der Platte, die dann als Ausschußware aussortiert werden muß.

Aufgabe der Erfindung ist es, eine Vorrichtung der eingangs beschriebenen Art so auszugestalten, daß sie die Vorderkante von Platten, Schichtträgern und dergleichen Materialien, die im allgemeinen geringe Biegesteifigkeit besitzen, in einen Spalt zwischen zwei Walzen einer Laminierstation mit großer Zielgenauigkeit und Sicherheit einführt und eine exakte und lagenmäßig gleichbleibende Positionierung der Vorderkante von Platten, Schichtträgern, Multilayerschichten und dgl. Materialien in Bezug zu einer Greifereinrichtung ermöglicht, durch die sich die Materialien in ihrer Transportrichtung erstrecken und aus der sie um eine vorgegebene Strecke herausragen.

Diese Aufgabe wird erfindungsgemäß dadurch gelöst, daß die Greifereinrichtung zwei Greiferleisten umfaßt, die zwischen der Laminierstation und horizontalen Transportrollen so angeordnet sind, daß die untere Greiferleiste mit ihrer durchgehenden Auflagefläche, die über die Breite des Schichtträgers auf beiden Seiten hinausragt, in der von den Transportrollen vorgegebenen Transportebene liegt, daß die obere, vertikal verstellbare Greiferleiste mit durchgehender Auflagefläche gleichlang wie die untere Greiferleiste ist und in der Offenstellung der Greifereinrichtung sich oberhalb der Transportebene befindet, und daß die untere Greiferleiste mit ihren Außenenden auf Stützen befestigt ist, die mit der Querstrebe verbunden sind und die jeweils ein durchgehendes Loch aufweisen, durch das eine Stange hindurchgeführt ist, die mit einem Pneumatikzylinder an dem einen Ende und mit der oberen Greiferleiste an dem anderen Ende verbunden ist.

Eine weitere Ausführungsform der Erfindung zeichnet sich dadurch aus, daß ein Sensor zum Erfassen der Vorderkante des Schichtträgers auf einem Haltewinkel angeordnet ist, der an einem Halteblock befestigt ist, der in Transportrichtung A des Schichtträgers verfahrbar ist und daß sich der Sensor in der Offenstellung der Greifereinrichtung in einem einstellbaren Abstand $X_{min}$ vor den Vorderkanten der Greiferleisten der Greifereinrichtung befindet.

In Ausgestaltung der Erfindung stellt eine Linearführung die Verbindung zwischen dem Halteblock und der Querstrebe her, die die Stützen miteinander verbindet, auf denen die untere Greiferleiste befestigt ist, des weiteren ist ein lagefestes Teil der Linearführung auf der Unterseite einer Grundplatte angebracht, die mit der Unterseite der querwinkelförmigen Strebe verbunden ist, und ist ein bewegliches Teil der Linearführung an dem Halteblock befestigt.

In Weiterbildung der Erfindung weisen die obere und untere Greiferleiste jeweils in der Mitte ihres abgeschrägten Leistenteils einen Durchbruch auf, so daß bei der Vorwärtsbewegung der Greifereinrichtung in Transportrichtung A der Sensor in den Bereich des Durchbruchs der unteren Greiferleiste gelangt und liegt die Querstrebe der Greifereinrichtung an dem Haltewinkel mit dem Sensor an und schiebt diesen bei der weiteren Vorwärtsbewegung der Greifereinrichtung mit nach vorne in Richtung Laminierstation.

Zur Einhaltung des vorgegebenen Abstandes $X_{min}$ ist eine zur Transportrichtung A parallele Anschlagstange mit einer Gewindebohrung in dem Halteblock in Eingriff und durchsetzt einen abgewinkelten Teil der Grundplatte und sitzt ferner ein Stellring auf der Anschlagstange nahe dem freien Ende auf.

Zweckmäßigerweise umgibt die Anschlagstange zwischen dem Stellring und der abgewinkelten Grundplatte eine Feder, die sich mit einem Ende gegen die Außenseite des abgewinkelten Teils der Grundplatte und mit dem anderen Ende gegen den Stellring abstützt. Dabei liegt das freie Ende der Anschlagstange an einer Maschinentraverse an und ist der Abstand zwischen dem freien Ende der Anschlagstange und dem Halteblock bzw. der vorderen Stellung des Sensors fest vorgegeben. bei einer anderen Ausgestaltung der Erfindung liegt das freie Ende der Anschlagstange an einem Anschlag an, der in die Maschinentraverse eingeschraubt und in seiner jeweiligen Position durch eine Kontermutter gesichert ist. Dabei ist der Abstand zwischen dem abgewinkelten Teil der Grundplatte und dem beweglichen Teil der Linearführung, bei an dem Anschlag bzw. an der Maschinentraverse anliegender Anschlagstange größer als der Abstand $X_{min}$.

Die Erfindung wird im folgenden anhand von zeichnerisch dargestellten Ausführungsbeispielen näher erläutert.

Es zeigen:

Fig. 1    eine schematische Schnittansicht einer ersten Ausführungsform der Vorrichtung nach der Erfindung,

Fig. 2    eine perspektivische Ansicht der Ausführungsform nach Fig. 1,

Fig. 3    eine vergrößerte Ansicht eines Details einer zweiten Ausführungsform, die sich nur in diesem Detail von der ersten bzw. dritten Ausführungsform unterscheidet,

Fig. 4    eine perspektivische Ansicht einer dritten Ausführungsform, die gegenüber der ersten und zweiten Ausführungsform geringfügig abgewandelt ist,

Fig. 5    eine schematische Schnittansicht einer vierten Ausführungsform der Vorrichtung nach der Erfindung,

Fig. 6    eine perspektivische Ansicht der Vorrichtung nach Fig. 5,

Fig. 7    eine schematische Schnittansicht einer fünften Ausführungsform der Vorrichtung nach der Erfindung, und

Fig. 8    eine perspektivische Ansicht der Vorrichtung nach Fig. 7.

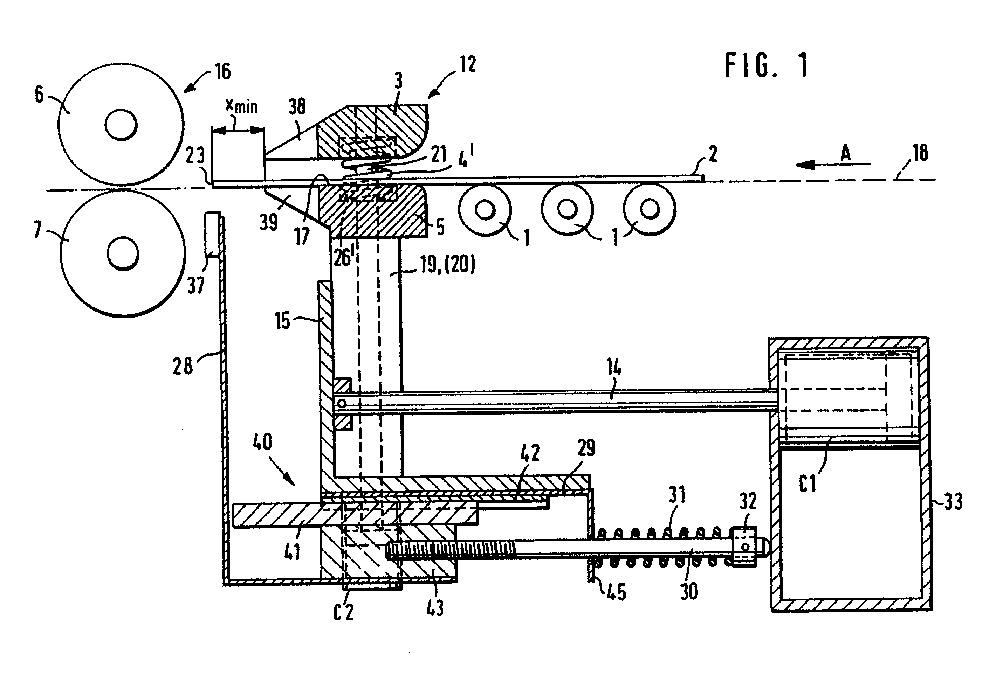

Fig. 1 zeigt einen Ausschnitt aus einer Verarbeitungsanlage für Schichtträger, Multilayer, Trägerplatten für gedruckte Schaltungen u.dgl. Materialien im Schnitt. Einer Laminierstation 16, bestehend aus zwei Laminierwalzen 6 und 7 wird in einer Transportebene 18 ein - Schichtträger 2 zugeführt. Die Transportebene 18 ist eine horizontal verlaufende Tangentialebene an Transportrollen 1. Die Umfangsgeschwindigkeit der Laminierwalzen 6 und 7 ist im allgemeinen größer als die Transportgeschwindigkeit des Schichtträgers 2.

Die untere Laminierwalze 7 ist beispielsweise ortsfest gelagert, während die obere Laminierwalze 6 in Vertikalrichtung beweglich gelagert ist, wodurch eine Veränderung des Spaltes zwischen den Laminierwalzen in vorgegebenen Grenzen von etwa 0,5 bis 7 mm möglich ist.

Die Laminierwalzen 6 und 7 werden von einem nicht dargestellten Motor mit gleicher Umfangsgeschwindigkeit angetrieben.

Der Schichtträger 2, beispielsweise eine Multilayerschicht, eine Trägerplatte für gedruckte Schaltungen, oder dergl. Material wird von einer nicht dargestellten Heizstation, in der der Schichtträger beidseitig erwärmt wird, in der gestrichelt gezeichneten Transportebene 18 in Transportrichtung A über die Transportrollen 1, von denen eine oder mehrere angetrieben sind, solange transportiert, bis die Vorderkante des Schichtträgers 2 den vertikalen Strahlengang eines Sensors 37 unterbricht, wodurch die Pneumatik der Greifereinrichtung mit einem Steuersignal des Sensors 37 beaufschlagt wird und die Greifereinrichtung schließt, um den Schichtträger 2 für das nachfolgende Einführen in die Laminierstation 16 festzuhalten. Die Greifereinrichtung 12 besteht aus zwei Greiferleisten 3 und 5 und ist zwischen der Laminierstation 16 und den horizontalen Transportrollen 1 so angeordnet, daß die untere Greiferleiste 5 in der Transportebene 18 liegt und die obere Greiferleiste 3, die vertikal verstellbar ist, sich in der Offenstellung der Greifereinrichtung 12 oberhalb der Transportebene 18 befindet. Die Greifereinrichtung 12 ist horizontal hin- und herverschiebbar, mit Hilfe eines Pneumatikzylinders $C_1$, der über eine Stange 14 mit der Greifereinrichtung 12 verbunden ist. Die Stange 14 ist eine verlängerte Kolbenstange des Pneumatikzylinders $C_1$, der beispielsweise innerhalb einer Maschinentraverse 33 liegt.

Der Sensor 37 zum Erfassen der Vorderkante des Schichtträgers 2 ist auf einem Haltewinkel 28 angeordnet, der an der Unterseite eines Halteblocks 43 befestigt ist. Der Sensor 37 befindet sich in der Offenstellung der Greifereinrichtung 12 in einem einstellbaren Abstand $X_{min}$ vor den Vorderkanten der Greiferleisten 3 und 5 der Greifereinrichtung 12. Die obere und untere Greiferleiste 3 und 5 besitzen jeweils in der Mitte ihrer abgeschrägten Leistenteile einen Durchbruch 38 bzw. 39, den bzw. die der Strahl des Sensors 37 durchsetzt, sobald die Greiferleisten 3 und 5 in den Bereich des Sensors 37, wie später noch erläutert werden wird, gelangen.

Der Halteblock 43 ist in Horizontalrichtung hin und her verschiebbar. Die Verbindung zwischen dem Halteblock 43 und einer winkelförmigen Querstrebe 15 stellt eine Linearführung 40 her, die aus einem lagefesten Teil 42 und einem beweglichen Teil 41 besteht. Das lagefeste Teil 42 ist auf der Unterseite einer Grundplatte 29 angebracht, die mit der Unterseite der Querstrebe 15 verbunden ist. Das bewegliche Teil 41 der Linearführung 40 ist an dem Halteblock 43 befestigt, der eine Gewindebohrung 35 aufweist, mit der eine Anschlagstange 30 im Eingriff ist, die parallel zu der Transportrichtung A und unterhalb der Stange 14 des Pneumatikzylinders $C_1$ verläuft. Die Anschlagstange 30 durchsetzt einen abgewinkelten, vertikal verlaufenden Teil 45 der Grundplatte 29. Auf der Anschlagstange 30 befindet sich nahe ihrem freien Ende ein Stellring 32, dessen Stellung auf der Anschlagstange 30 frei wählbar ist und der in seiner jeweiligen Stellung mittels einer versenkten Madenschraube festgehalten wird. Zwischen dem Stellring 32 und dem abgewinkelten Teil 45 der Grundplatte 29 umgibt eine Feder 31 die Anschlagstange 30. Diese Feder 31 stützt sich mit einem Ende gegen die Außenseite des abgewinkelten Teils 45 der Grundplatte 29 und mit dem anderen Ende gegen den Stellring 32 ab. Entsprechend der jeweiligen Lage bzw. Stellung des Stellrings 32 auf der Anschlagstange 30 wird die Feder 31 bei der gegenüber der Transportrichtung A entgegengesetzten Bewegung der Kolbenstange 14 des Pneumatikzylinders $C_1$ durch den abgewinkelten Teil 45 der Grundplatte 29 stärker oder weniger stark zusammengedrückt, wobei das freie Ende der Anschlagstange 30 an der Maschinentraverse 33 anliegt. Der Abstand zwischen dem freien Ende der Anschlagstange 30 und dem Halteblock 43 bzw. der vorderen Stellung des Sensors 37 ist fest vorgegeben. Dieser Abstand hängt davon ab, wieweit die Anschlagstange 30 in die Gewindebohrung 35 des Halteblocks 43 eingeschraubt ist.

Der Abstand zwischen dem abgewinkelten Teil 45 der Grundplatte 29 und dem beweglichen Teil 41 der Linearführung 40, wenn die Anschlagstange 30 an der Maschinentraverse 33 anliegt, ist größer als der Abstand $X_{min}$.

Der Sensor 37, der im allgemeinen ein optoelektronischer Sensor ist, ist so angeordnet, daß sein Strahlengang in dem vorgegebenen Abstand $X_{min}$ vor der Greifereinrichtung 12 liegt, wenn diese im eingefahrenen Zustand des Pneumatikzylinders $C_1$ ihre am weitesten von der Laminierstation 16 entfernte Position einnimmt. Sobald die Vorderkante des Schichtträgers 2 den Strahlengang des Sensors 37 unterbricht, schließt die Greifereinrichtung 12, und der Pneumatikzylinder $C_1$ wird in Richtung Laminierstation 16 ausgefahren. Die Vorderkante 23 wird durch die Greifereinrichtung 12 möglichst weit in den Spalt zwischen den Laminierwalzen 6 und 7 hineingeführt, was durch die Abschrägung der Greiferleisten 3 und 5 erleichtert wird und wodurch sichergestellt ist, daß beim Öffnen der Greifereinrichtung 12 der Schichtträger von den umlaufenden Laminierwalzen sofort erfaßt und weitertransportiert wird.

Bei der Vorwärtsbewegung der Greifereinrichtung 12 in Transportrichtung A verschiebt sich das Teil 42 der Linearführung 40 entlang dem Teil 41, das an dem Halteblock 43 befestigt ist, wobei der Sensor 37 bzw. der Haltewinkel 28 zunächst seine Position unverändert beibehält. Während der weiteren Vorwärtsbewegung der Greifereinrichtung 12 in Transportrichtung A kommt die Querstrebe 15 der Greifereinrichtung an dem Haltewinkel 28 mit dem Sensor 37 zum Anliegen, der dadurch in den Bereich des Durchbruchs 39 der unteren Greiferleiste 5 gelangt, was in Fig. 1 nicht dargestellt ist. Der Sensor wird dann bei der weiteren Vorwärtsbewegung der Greifereinrichtung mit nach vorne in Richtung Laminierstation 16 geschoben. Sobald der Schichtträger 2 an die Laminierstation 16 übergeben ist, wird die geöffnete Greifereinrichtung 12 durch den Pneumatikzylinder $C_1$, nach rechts, in Fig. 1, zurückgefahren, wobei die Anschlagstange 30 mit ihrem freien Ende an der Maschinentraverse 33 zum Anliegen gelangt. Der Sensor 37 bzw. der Haltewinkel 28 nehmen dann wieder ihre Anfangsposition ein, in der die Stellung des Sensors 37 vor den Vorderkanten der Greiferleisten 3 und 5 fest vorgegeben ist.

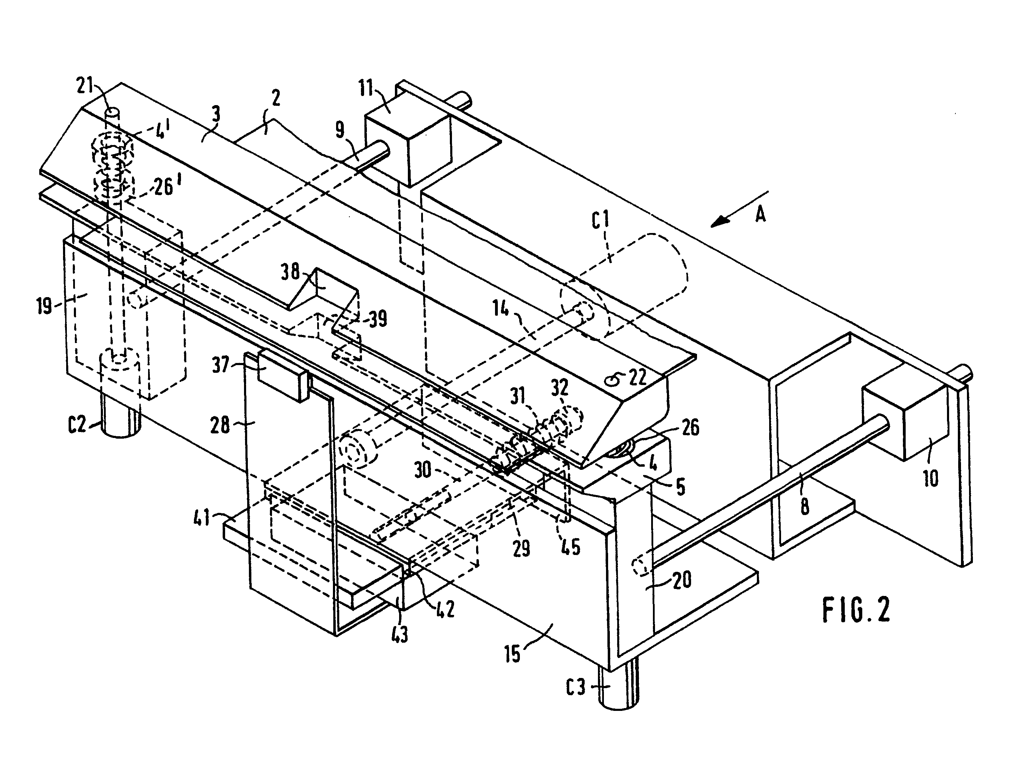

In Fig. 2 werden zur besseren Übersichtlichkeit die Laminierstation 16, die Transportrollen 1, die Maschinentraverse 33 sowie die Anschlagstange 30, die in Fig. 1 dargestellt sind, weggelassen.

Wie Fig. 2 zeit, ist die untere Greiferleiste 5 lagefest und liegt mit ihrer der Auflagefläche für den Schichtträger 2 gegenüberliegenden Unterseite auf zwei Stützen 19,20 auf. Der Pneumatikzylinder $C_1$ mit der Stange 14 ist an der Querstrebe 15 der Greifereinrichtung 12 mittig angelenkt. Die Greifereinrichtung 12 ist mit zwei Führungsstangen 8 und 9 verbunden, von denen jede in einer Linearführung 10 und 11 geführt ist. Die Führungsstangen 8 und 9 sind in den Stützen 19 und 20 gelagert, auf denen die untere Greiferleiste 5 mit den Außenenden ihrer Unterseite befestigt ist. Die Querstrebe 15 verbindet die beiden Stützen 19 und 20 miteinander und besitzt in der Mitte zwei rechtwinklig zur Querstrebe 15 angebrachte Vorsprünge, zwischen denen die Stange 14 des Pneumatikzylinders $C_1$ eingefügt und angelenkt ist (in Fig. 1 nicht dargestellt). Jede der Stützen 19 und 20 hat ein durchgehendes Loch, durch das eine Stange 21 bzw. 22 hindurchgeführt ist, die mit einem Pneumatikzylinder $C_2$ bzw. $C_3$ an dem unteren Ende und mit der oberen Greiferleiste 3 an dem oberen Ende verbunden ist. In der Auflagefläche 17 der unteren Greiferleiste 5 befinden sich Ausnehmungen 26,26' rings um die Stangen 21 und 22, die in diesem Bereich von Federn 4,4' umgeben sind. Die oberen Enden der Federn stützen sich in Ausnehmungen der oberen Greiferleiste 3 und die unteren Enden auf den Bodenflächen der Ausnehmungen 26,26' der unteren Greiferleiste 5 ab bzw. sind mit diesen verbunden. Die Federn 4,4' können Zugfedern oder auch Druckfedern sein. Im Falle von Zugfedern ziehen diese die obere Greiferleiste 3 gegen die untere Greiferleiste 5, wenn die Pneumatikzylinder $C_2$ und $C_3$ drucklos sind. Bei Druckbeaufschlagung der Pneumatikzylinder $C_2$ und $C_3$ wird die obere Greiferleiste 3 in die Offenstellung der Greifereinrichtung 12 gegen die Zugkraft der Federn 4,4' nach oben verschoben.

Handelt es sich bei den Federn 4,4' um Druckfedern, die bei drucklosen Pneumatikzylindern $C_2$ und $C_3$ die obere Greiferleiste 3 von der unteren Greiferleiste 5 abheben, so erfolgt durch eine Druckbeaufschlagung der Pneumatikzylinder $C_2$ und $C_3$, die in diesem Fall umgekehrt zu den Pneumatikzylindern $C_2$ und $C_3$ für Zugfedern arbeiten müssen, eine Bewegung der oberen Greiferleiste 3 nach unten gegen die Druckkraft der Federn in die Schließstellung der Greifereinrichtung 12.

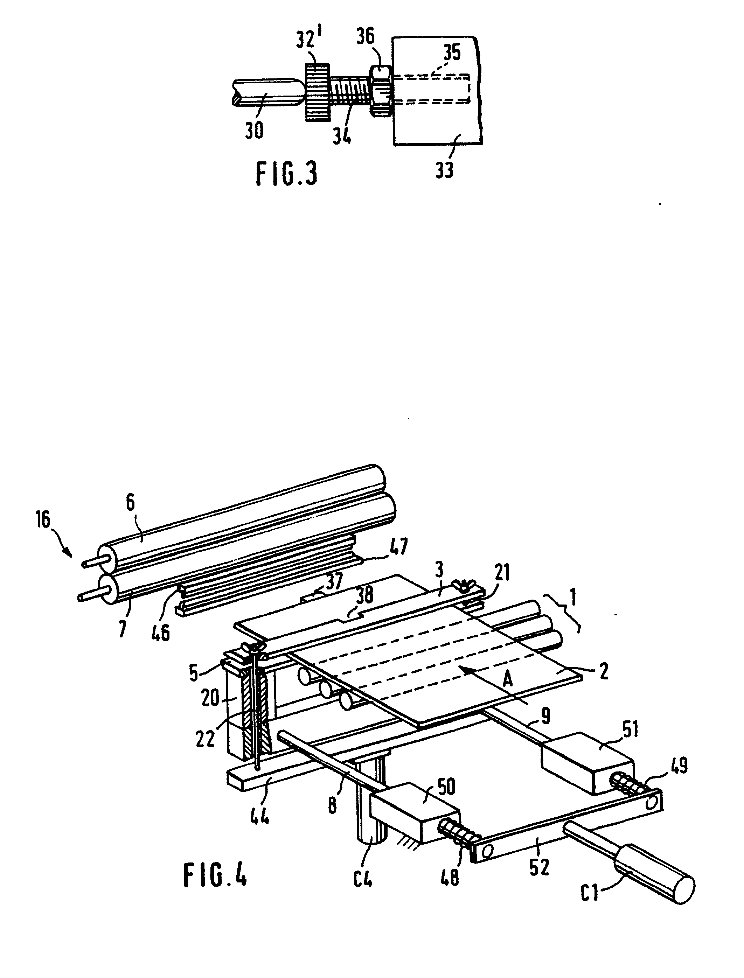

Fig. 3 zeigt in vergrößerter Ansicht ein Detail einer zweiten Ausführungsform der Erfindung, wobei dieses Detail sowohl in der ersten Ausführungsform gemäß den Fig. 1 und 2 als auch in der dritten Ausführungsform gemäß Fig. 4 vorgesehen werden kann. Es handelt sich hierbei um einen Anschlag 34, der in die Maschinentraverse 33 eingeschraubt und in seiner jeweiligen Position durch eine Kontermutter 36 gesichert ist. Dazu ist in der Maschinentraverse 33 eine Gewindebohrung 35 vorhanden, in die der Anschlag 34 unterschiedlich tief eingeschraubt werden kann. Auf dem freien Ende des Anschlags 34 sitzt ein Stellring 32' auf, gegen den das freie Ende der Anschlagstange 30 in der Ausgangsposition der Greifereinrichtung anliegt. Durch das Verstellen des Anschlags 34 innerhalb der Gewindebohrung 35 kann der Abstand $X_{min}$ des Sensors 37 von den Vorderkanten der Greiferleisten 3 und 5 innerhalb eines vorgegebenen Bereichs verändert werden.

Die in Fig. 4 dargestellte Ausführungsform, bei der aus Gründen der besseren Übersichtlichkeit die Grundplatte, die Anschlagstange 30 sowie die Maschinentraverse 33 weggelassen wurden, ist ähnlich zu der ersten Ausführungsform aufgebaut, mit dem einen Unterschied, daß anstelle zweier Pneumatikzylinder $C_2$, $C_3$ ein einzelner Pneumatikzylinder $C_4$ mit einer Traverse 44 mittig verbunden ist, um diese auf und ab zu bewegen. Der Pneumatikzylinder $C_4$ überträgt beim Einfahren über die Traverse 44 und die Stangen 21,22, die beispielsweise mit Flügelmuttern auf der Oberseite der oberen Greiferleiste 3 verschraubt sind, die Zugkraft auf die Greiferleiste 3 für den Schließvorgang der Greifereinrichtung.

Bei dieser Ausführungsform sind unmittelbar vor der Laminierstation 16 Auftragseinrichtungen 46,47 angeordnet, um auf die Ober- und Unterseite des Schichtträgers 2 eine Flüssigkeit auftragen zu können. Die zwei zueinander parallelen, horizontalen Führungsstangen 8 und 9 durchsetzen Führungslager 50 und 51 und werden beispielsweise durch eine Querstrebe 52, an den Stangenenden, miteinander verbunden. Auf der Rückseite der Querstrebe 52 greift die Kolbenstange des Pneumatikzylinders $C_1$ für das horizontale Hin- und Herbewegen der Greifereinrichtung an. Die Führungsstangen 8 und 9 sind über die Führungslager 50 und 51 nach hinten hinausgeführt und von Federn 48 und 49 umgeben, die mit den einen Enden an den Rückseiten der Führungslager 50 und 51 und mit den anderen Enden an der Querstrebe 52 anliegen. Ist der Pneumatikzylinder $C_1$ drucklos, so wird die Greifereinrichtung durch die Federn 48 und 49 bis in eine vorgegebene Position in Transportrichtung A verschoben.

Die übrigen in Fig. 4 dargestellten Bauteile stimmen weitgehend mit denjenigen in den Fig. 1 und 2 überein und werden daher nicht mehr beschrieben.

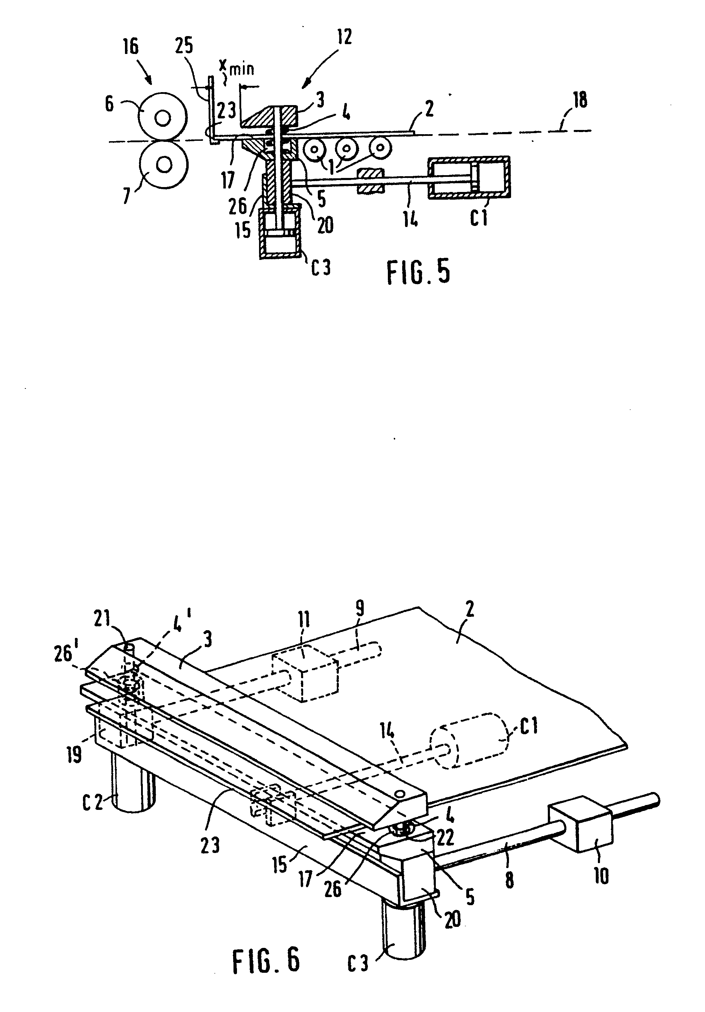

Fig. 5 zeigt in schematischer Schnittansicht eine weitere Ausführungsform der Beschickungsvorrichtung, ähnlich der Vorrichtung nach Fig. 1. Der Laminierstation 16, bestehend aus zwei Laminierwalzen 6 und 7 wird in der Transportebene 18 der Schichtträger 2 zugeführt.

Der Schichtträger 2, beispielsweise eine Multilayerschicht, eine Trägerplatte für gedruckte Schaltungen, oder dergleichen Material wird von einer nicht dargestellten Heizstation, in der der Schichtträger beidseitig erwärmt wird, in der gestrichelt gezeichneten Transportebene 18 über die Transportrollen 1, von denen eine oder mehrere angetrieben sind, bis zu einem Anschlag 25 transportiert. Der winkelförmige Anschlag 25 ragt in die Wegstrecke des Schichtträgers 2 hinein und ist mit einem nicht gezeigten Pneumatikzylinder mit Magnetventil verbunden, der ihn aus der Wegstrecke herauszieht, wenn das Magnetventil mit einem entsprechenden Steuerimpuls beaufschlagt wird.

Die Greifereinrichtung 12 umfaßt zwei Greiferleisten 3 und 5 und ist zwischen der Laminierstation 16 und den horizontalen Transportrollen 1 so angeordnet, daß die untere Greiferleiste 5 in der Transportebene 18 liegt und die obere Greiferleiste 3, die vertikal verstellbar ist, in der Offenstellung der Greifereinrichtung 12 sich oberhalb der Transportebene 18 befindet. Die Greifereinrichtung 12 ist horizontal hin und her verschiebbar, mit Hilfe eines Pneumatikzylinders $C_1$, der über eine Stange 14 mit der Greifereinrichtung 12 verbunden ist. Die Stange 14 ist eine verlängerte Kolbenstange des Pneumatikzylinders $C_1$. Der Anschlag 25 ist so angeordnet, daß die Vorderkante 23 des Schichtträgers 2 in einem vorgegebenen Abstand $x_{min}$ vor der Greifereinrichtung 12 liegt, wenn diese im eingefahrenen Zustand des Pneumatikzylinders $C_1$ ihre am weitesten von der Laminierstation 16 entfernte Position einnimmt. Sobald die Greifereinrichtung 12 schließt, wird der Anschlag 25 aus der Transportebene 18 bzw. aus der Wegstrecke des Schichtträgers 2 herausgezogen und der Pneumatikzylinder $C_1$ in Richtung Laminierstation 16 ausgefahren. Die Vorderkante 23 wird durch die Greifereinrichtung 12 möglichst weit in den Spalt zwischen den Laminierwalzen 6 und 7 hineingeführt, wodurch sichergestellt ist, daß beim Öffnen der Greifereinrichtung 12 der Schichtträger 2 von den umlaufenden Laminierwalzen sofort erfaßt und weitertransportiert wird. Der Abstand $x_{min}$ wird so groß gewählt, daß er ungefähr dem Radius der Laminierwalzen 6 und 7 entspricht, wodurch auch bei geringer Biegesteifigkeit von dünnen Schichtträgern 2 sichergestellt ist, daß eine exakte Übergabe des Schichtträgers 2 von der Greifereinrichtung 12 an die Laminierstation 16 erfolgt. Da der Abstand $x_{min}$ maximal in der Größenordnung von 3 bis 4 cm liegt, erfolgt auch bei geringer Biegesteifigkeit des Schichtträgers 2 keine Durchbiegung, so daß die Vorderkante 23 des Schichtträgers 2 präzise in den Spalt zwischen den Laminierwalzen eingeführt werden kann und eine weitgehend störungsfreie Übergabe von der Greifereinrichtung 12 auf die Laminierstation 16 erfolgt.

Die untere Greiferleiste 5 ist lagefest und liegt mit ihrer Auflagefläche 17 für den Schichtträger 2 in der von den Transportrollen 1 vorgegebenen Transportebene 18.

Wie Figur 6 zeigt, ist der Pneumatikzylinder C1 mit der Stange 14 in der Mitte des Abstandes zweier Führungsstangen 8 und 9 voneinander an der Querstrebe 15 der Greifereinrichtung 12 angelenkt. Die Greifereinrichtung 12 ist an den beiden Führungsstangen 8 und 9 befestigt, von denen jede in einer Linearführung 10 und 11 geführt ist. Die Führungsstangen 8 und 9 sind desweiteren in Stützen 19 und 20 gelagert, auf denen die untere Greiferleiste 5 mit ihren Außenenden befestigt ist. Die Querstrebe 15 verbindet die beiden Stützen 19 und 20 miteinander und besitzt in der Mitte zwei rechtwinklig zur Querstrebe 15 angebrachte Vorsprünge, zwischen denen die Stange 14 des Pneumatikzylinders $C_1$ eingefügt und angelenkt ist. Jede der Stützen 19 und 20 weist ein durchgehendes Loch auf, durch das eine Stange 21 bzw. 22 hindurchgeführt ist, die mit einem Pneumatikzylinder $C_2$ bzw. $C_3$ an dem unteren Ende und mit der oberen Greiferleiste 3 an dem oberen Ende verbunden ist. In der Auflagefläche 17 der unteren Greiferleiste 5 befinden sich Ausnehmungen 26, 26' rings um die Stangen 21 und 22, die in diesem Bereich von Federn 4, 4' umgeben sind. Die oberen Enden der Federn sind mit der oberen Greiferleiste 3 und die unteren Enden mit den Bodenflächen der Ausnehmungen 26, 26' der unteren Greiferleiste 5 in Verbindung. Die Federn 4, 4' können Zugfedern oder auch Druckfedern sein. Im Falle von Zugfedern ziehen diese die obere Greiferleiste 3 gegen die untere Greiferleiste 5, wenn die Pneu-

matikzylinder $C_2$ und $C_3$ drucklos sind. Bei Druckbeaufschlagung der Pneumatikzylinder $C_2$ und $C_3$ wird die obere Greiferleiste 3 in die Offenstellung der Greifereinrichtung 12 gegen die Zugkraft der Federn 4, 4' nach oben verschoben.

Handelt es sich bei den Federn 4, 4' um Druckfedern, die bei drucklosen Pneumatikzylindern $C_2$ und $C_3$ die obere Greiferleiste 3 von der unteren Greiferleiste 5 abheben, so erfolgt durch eine Druckbeaufschlagung der Pneumatikzylinder $C_2$ und $C_3$, die in diesem Fall umgekehrt zu den Pneumatikzylindern $C_2$ und $C_3$ für Zugfedern arbeiten müssen, eine Bewegung der oberen Greiferleiste 3 gegen die Druckkraft der Federn in die Schließstellung der Greifereinrichtung 12 nach unten.

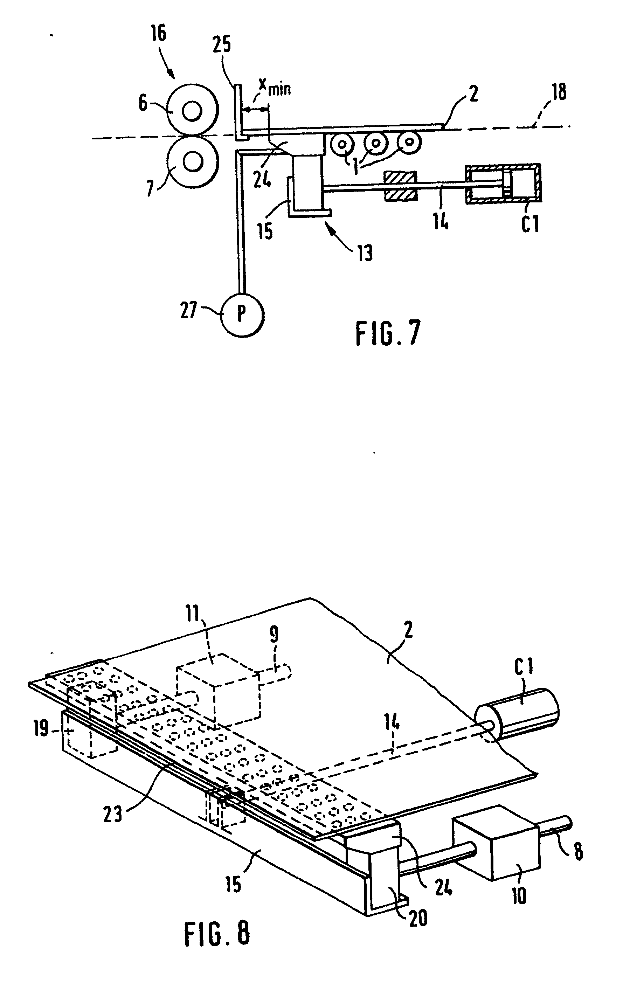

In den Figuren 7 und 8 ist eine weitere Ausführungsform einer Greifereinrichtung 13 dargestellt, die ähnlich zu der Greifereinrichtung 12 nach den Figuren 5 und 6 aufgebaut ist. Übereinstimmende Bauteile der beiden Greifereinrichtungen sind mit den gleichen Bezugszahlen belegt und ihre Beschreibung wird nicht mehr wiederholt.

Gegenüber der Greifereinrichtung 12 nach den Figuren 5 und 6 ergeben sich die Unterschiede, daß die Greifereinrichtung 13 eine einzige Leiste 24 aufweist, die als Saugleiste ausgebildet ist und daß die Pneumatikzylinder $C_2$ und $C_3$ zusammen mit der oberen Greiferleiste entfallen. Die Leiste 24 ist mit einer Vakuum- bzw. Saugpumpe 27 verbunden, die für einen Unterdruck in der Saugleiste 24 sorgt, wenn der Schichtträger 2 festgehalten werden soll. Hierfür ist eine Saugfläche der Leiste 24 vorgesehen, in der Sauglöcher mit relativ kleinem Durchmesser angeordnet sind. Sobald die Vakuumpumpe eingeschaltet ist, entsteht in der Leiste 24 ein Unterdruck, und der Schichtträger 2 wird an die Saugfläche angesaugt und festgehalten. Die Saugfläche liegt in der von den Transportrollen 1 gebildeten Transportebene 18 und in einem vorgegebenen Abstand $x_{min}$ von der Vorderkante 23 des Schichtträgers 2. Sobald die Leiste 24 mit Unterdruck beaufschlagt ist, um den Schichtträger 2 für den Weitertransport zu der Laminierstation 16 anzusaugen, wird der Anschlag 25 aus der Transportebene 18 herausgezogen und die Greifereinrichtung 13 durch den Pneumatikzylinder $C_1$ die Stange 14 an die winkelförmige Querstrebe 15 angelenkt ist, in Richtung Laminierstation 16 verschoben. Der weitere Transport des Schichtträgers 2 durch die Laminierstation 16 erfolgt in der zuvor anhand der Figuren 5 und 6 beschriebenen Weise.

Die Greiferleisten 3 und 5 der Greifereinrichtung 12 nach den Figuren 5 und 6 sind gleich lang und erstrecken sich über die Breite, d.h. die beiden Schichtränder in Längsrichtung des Schichtträgers hinaus. Die Greiferleisten bilden somit über die gesamte Schichtträgerbreite geschlossene Angriffsflächen, wodurch sich gegenüber Greifereinrichtungen mit punktförmigen Griffstellen der Vorteil einer erwünschten Versteifung der Vorderkante des Schichtträgers, insbesondere im Fall einer Multilayerschicht, während des Transports ergibt.

In den Figuren 6 und 8 wurden aus Gründen der besseren Übersichtlichkeit die Transportrollen weggelassen.

## Ansprüche

1. Vorrichtung zum automatischen Beschicken einer Laminierstation mit einem Schichtträger, einer aus zumindest einer Greiferleiste bestehenden Greifereinrichtung, die an zwei Führungsstangen, von denen jede in einer Linearführung geführt ist, horizontal mittels eines Pneumatikzylinders hin- und herfahrbar angeordnet ist, der über eine Stange mit einer Querstrebe der Greifereinrichtung verbunden ist, wobei der Pneumatikzylinder in der Mitte des Abstandes der beiden Führungsstangen voneinander angeordnet ist, dadurch gekennzeichnet, daß die Greifereinrichtung (12) zwei Greiferleisten (3, 5) umfaßt, die zwischen der Laminierstation (16) und horizontalen Transportrollen (1) so angeordnet sind, daß die untere Greiferleiste (5) mit ihrer durchgehenden Auflagefläche (17), die über die Breite des Schichtträgers (2) auf beiden Seiten hinausragt, in der von den Transportrollen (1) vorgegebenen Transportebene (18) liegt, daß die obere, vertikal verstellbare Greiferleiste (3) mit durchgehender Auflagefläche gleichlang wie die untere Greiferleiste (5) ist und in der Offenstellung der Greifereinrichtung (12) sich oberhalb der Transportebene befindet, und daß die untere Greiferleiste (5) mit ihren Außenenden auf Stützen (19, 20) befestigt ist, die mit der Querstrebe (15) verbunden sind und die jeweils ein durchgehendes Loch aufweisen, durch das eine Stange (21, 22) hindurchgeführt ist, die mit einem Pneumatikzylinder ($C_2$, $C_3$) an dem einen Ende und mit der oberen Greiferleiste (3) an dem anderen Ende verbunden ist.

2. Vorrichtung nach Anspruch 1, dadurch gekennzeichnet, daß die Stangen (21, 22) im oberen Bereich von Federn (4, 4') umgeben sind, die mit ihren oberen Enden mit der oberen Greiferleiste (3) und mit ihren unteren Enden mit Bodenflächen von Ausnehmungen (26, 26') in der unteren Greiferleiste (5) in Verbindung stehen.

3. Vorrichtung nach Anspruch 2, dadurch gekennzeichnet, daß die Federn (4, 4') Zugfedern sind, die die obere Greiferleiste (3) gegen die untere Greiferleiste (5) ziehen und daß die obere Greiferleiste (3) in die Offenstellung der Greifereinrichtung (12) durch Druckbeaufschlagung der Pneumatikzylinder (C₂, C₃) gegen die Zugkraft der Federn nach oben verschiebbar ist.

4. Vorrichtung nach Anspruch 2, dadurch gekennzeichnet, daß die Federn (4, 4') Druckfedern sind, welche die obere Greiferleiste (3) von der unteren Greiferleiste (5) abheben und daß durch Betätigen der Pneumatikzylinder (C₂, C₃) die obere Greiferleiste (3) gegen die Druckkraft der Federn in die Schließstellung der Greifereinrichtung (12) nach unten verfahrbar ist.

5. Vorrichtung nach Anspruch 1, dadurch gekennzeichnet, daß die Greifereinrichtung (12; 13) in einem vorgegebenen Abstand $x_{min}$ von der Vorderkante (23) den Schichtträger (2) erfaßt.

6. Vorrichtung nach Anspruch 1, dadurch gekennzeichnet, daß die Greifereinrichtung (13) eine einzige Leiste (24) aufweist, die als Saugleiste ausgebildet ist.

7. Vorrichtung nach Anspruch 6, dadurch gekennzeichnet, daß die Leiste (24) mit ihrer Saugfläche in der von den Transportrollen (1) gebildeten Transportebene (18) liegt und in einem vorgegebenen Abstand $x_{min}$ von der Vorderkante (23) des Schichtträgers (2) mit Unterdruck beaufschlagbar ist, um den Schichtträger (2) für den Weitertransport zu der Laminierstation (16) anzusaugen.

8. Vorrichtung nach Anspruch 1, dadurch gekennzeichnet, daß ein Sensor (37) zum Erfassen der Vorderkante des Schichtträgers (2) auf einem Haltewinkel (28) angeordnet ist, der an einem Halteblock (43) befestigt ist, der in Transportrichtung A des Schichtträgers (2) verfahrbar ist und daß sich der Sensor (37) in der Offenstellung der Greifereinrichtung (12) in einem einstellbaren Abstand $X_{min}$ vor den Vorderkanten der Greiferleisten (3,5) der Greifereinrichtung (12) befindet.

9. Vorrichtung nach Anspruch 8, dadurch gekennzeichnet, daß eine Linearführung (40) die Verbindung zwischen dem Halteblock (43) und der Querstrebe (15) herstellt, die die Stützen (19,20) miteinander verbindet, auf denen die untere Greiferleiste (5) befestigt ist, daß ein lagefestes Teil (42) der Linearführung (40) auf der Unterseite einer Grundplatte (29) angebracht ist, die mit der Unterseite der Querstrebe (15) verbunden ist und daß ein bewegliches Teil (41) der Linearführung (40) an dem Halteblock (43) befestigt ist.

10. Vorrichtung nach Anspruch 8, dadurch gekennzeichnet daß die obere und untere Greiferleiste (3,5) jeweils in der Mitte ihres abgeschrägten Leistenteils einen Durchbruch (38;39) aufweisen, daß bei der Vorwärtsbewegung der Greifereinrichtung (12) in Transportrichtung A der Sensor (37) in den Bereich des Durchbruchs (39) der unteren Greiferleiste (5) gelangt und daß die Querstrebe (15) der Greifereinrichtung an dem Haltewinkel (28) mit dem Sensor (37) anliegt und diesen bei der weiteren Vorwärtsbewegung der Greifereinrichtung mit nach vorne in Richtung Laminierstation (16) schiebt.

11. Vorrichtung nach Anspruch 9, dadurch gekennzeichnet, daß eine zur Transportrichtung A parallele Anschlagstange (30) mit einer Gewindebohrung (35) in dem Halteblock (43) in Eingriff ist und den abgewinkelten Teil (45) der Grundplatte (29) durchsetzt und daß ein Stellring (32) auf der Anschlagstange (30) nahe dem freien Ende aufsitzt.

12. Vorrichtung nach Anspruch 11, dadurch gekennzeichnet, daß zwischen dem Stellring (32) und der abgewinkelten Grundplatte (29) eine Feder (31) die Anschlagstange (30) umgibt, die sich mit einem Ende gegen die Außenseite des abgewinkelten Teils (45) der Grundplatte (29) und mit dem anderen Ende gegen den Stellring (32) abstützt.

13. Vorrichtung nach Anspruch 11, dadurch gekennzeichnet, daß das freie Ende der Anschlagstange (30) an einer Maschinentraverse (33) anliegt und daß der Abstand zwischen dem freien Ende der Anschlagstange (30) und dem Halteblock (43) bzw. der vorderen Stellung des Sensors (37) fest vorgegeben ist.

14. Vorrichtung nach Anspruch 11, dadurch gekennzeichnet, daß das freie Ende der Anschlagstange (30) an einem Anschlag (34) anliegt, der in die Maschinentraverse (33) eingeschraubt und in seiner jeweiligen Position durch eine Kontermutter (36) gesichert ist.

15. Vorrichtung nach den Ansprüchen 13 und 14, dadurch gekennzeichnet, daß der Abstand zwischen dem abgewinkelten Teil (45) der Grundplatte (29) und dem beweglichen Teil (41) der Linearführung (40), bei an dem Anschlag (34) bzw. an der Maschinentraverse (33) anliegender Anschlagstange (30), größer als der Abstand $X_{min}$ ist.

**Claims**

1. Apparatus for automatically feeding a layer support to a laminating station, with a gripper device which comprises at least one gripper strip and is arranged on two guide rods, each guided in a linear guide, so that it is movable to and fro horizontally by means of a pneumatic cylinder connected via a rod to a cross strut of the gripper device, the pneumatic cylinder being disposed in the center of the distance between the two guide rods, wherein the gripper device (12) comprises two gripper strips (3, 5) which are arranged between the laminating station (16) and horizontal transport rollers (1) in such a way that the lower gripper strip (5) lies with its continuous supporting surface (17), projecting beyond the width of the layer support (2) on both sides, in the transport plane (18) predetermined by the transport rollers (1) , wherein the upper vertically adjustable gripper strip (3) with continuous supporting surface is of the same length as the lower gripper strip (5) and is located above the transport plane when the gripper device (12) is in the open position, and wherein the lower gripper strip (5) is fastened by means of its outer ends to supports (19, 20) which are connected to the cross-strut (15) and which each have a through-hole, through which is guided a rod (21, 22) connected to a pneumatic cylinder (C2, C3) at one end and to the upper gripper strip (3) at the other end.

2. The apparatus as claimed in claim 1, wherein the rods (21, 22) are surrounded in the upper region by springs (4, 4') which are connected at their top ends to the upper gripper strip (3) and at their bottom ends to bottom surfaces of recesses (26, 26') in the lower gripper strip (5).

3. The apparatus as claimed in claim 2, wherein the springs (4, 4') are tension springs which pull the upper gripper strip (3) against the lower gripper strip (5), and wherein, when the pneumatic cylinders (C2, C3) are subjected to pressure, the upper gripper strip (3) can be displaced upwards into the open position of the gripper device (12) against the pulling force of the springs.

4. The apparatus as claimed in claim 2, wherein the springs (4, 4') are compression springs which lift the upper gripper strip (3) off from the lower gripper strip (5), and wherein, as a result of the actuation of the pneumatic cylinders (C2, C3), the upper gripper strip (3) is movable downwards into the closing position of the gripper device (12) against the compressive force of the springs.

5. The apparatus as claimed in claim 1, wherein the gripper device (12; 13) grips the layer support (2) at a predetermined distance $x_{min}$ from the front edge (23).

6. The apparatus as claimed in claim 1, wherein the gripper device (13) has a single strip (24) which is designed as a suction strip.

7. The apparatus as claimed in claim 6, wherein the strip (24) lies with its suction surface in the transport plane (18) formed by the transport rollers (1) and at a predetermined distance $x_{min}$ from the front edge (23) of the layer support (2) can be subjected to a partial vacuum, to suck up the layer support (2) for further transport to the laminating station (16).

8. The apparatus as claimed in claim 1, wherein a sensor (37) for detecting the front edge of the layer support (2) is located on a holding bracket (28) fastened to a holding block (43) movable in the transport direction A of the layer support (2), and wherein, when the gripper device (12) is in the open position, the sensor (37) is at an adjustable distance $x_{min}$ in front of the front edges of the gripper strips (3, 5) of the gripper device (12).

9. The apparatus as claimed in claim 8, wherein a linear guide (40) makes the connection between the holding block (43) and the cross-strut (15) which connects to one another the supports (19, 20), on which the lower gripper strip (5) is fastened, wherein a part (42) of the linear guide (40) which is fixed in position is attached to the underside of a base plate (29) connected to the underside of the cross-strut (15), and wherein a movable part (41) of the linear guide (40) is fastened to the holding block (43).

10. The apparatus as claimed in claim 8, wherein the upper and lower gripper strips (3, 5) each have a perforation (38; 39) in the center of their bevelled strip part, wherein the sensor (37) comes into the region of the perforation (39) of the lower gripper strip (5) during the forward movement of the gripper device (12) in the transport direction A, and wherein the cross-strut (15) of the gripper device rests against the holding bracket (28) with the sensor (37) and pushes the latter forward in the direction of the laminating station (16) during the further forward movement of the gripper device.

11. The apparatus as claimed in claim 9, wherein a stop rod (30) parallel to the transport direction A is engaged with a threaded bore (35) in the holding block (43) and passes through the angled part (45) of the base plate (29), and wherein a setting ring (32) is located on the stop rod (30) near to the free end.

12. The apparatus as claimed in claim 11, wherein, between the setting ring (32) and the angled base plate (29), the stop rod (30) is surrounded by a spring (31) which is supported at one end against the outside of the angled part (45) of the base plate (29) and at the other end against the setting ring (32).

13. The apparatus as claimed in claim 11, wherein the free end of the stop rod (30) rests against a machine cross-piece (33), and wherein the distance between the free end of the stop rod (30) and the holding block (43) or the front position of the sensor (37) is prefixed.

14. The apparatus as claimed in claim 11, wherein the free end of the stop rod (30) rests against a stop (34) which is screwed into the machine cross-piece (33) and which is secured in its particular position by a lock nut (36).

15. The apparatus as claimed in claims 13 and 14, wherein the distance between the angled part (45) of the base plate (29) and the movable part (41) of the linear guide (40), when the stop rod (30) rests against the stop (34) or against the machine cross-piece (33), is greater than the distance $x_{min}$.

**Revendications**

1. Dispositif pour alimenter automatiquement en support de couche un poste de doublage, avec un "preneur" qui est constitué d'au moins une barre "preneuse" et qui est disposé sur deux tiges de guidage, qui sont chacune guidées dans un guide linéaire, en pouvant être déplacé horizontalement en va-et-vient à l'aide d'un vérin pneumatique qui est relié par l'intermédiaire d'une tige à une entretoise du preneur, le vérin pneumatique étant disposé au milieu de l'espacement entre les deux tiges de guidage, caractérisé en ce que le preneur (12) comprend deux barres preneuses (3, 5) qui sont disposées entre le poste de doublage (16) et des rouleaux de transport horizontaux (1) de telle sorte que la surface d'appui continue (17) de la barre preneuse inférieure (5), laquelle surface d'appui dépasse des deux côtés de la largeur du support de couche (2), se situe dans le plan de transport (18) prédéterminé par les rouleaux de transport (1), en ce que la barre preneuse supérieure (3), verticalement réglable et présentant une surface d'appui continue, est de la même longueur que la barre preneuse inférieure (5) et se situe au-dessus du plan de transport lorsque le preneur (12) est en position ouverte, et en ce que la barre preneuse inférieure (5) est fixée par ses extrémités extérieures à des montants (19, 20) qui sont assemblés à l'entretoise (15) et qui présentent chacun un orifice traversant à travers lequel est guidée une tige (21, 22) qui est reliée à une extrémité à un vérin pneumatique ($C_2$, $C_3$) et à l'autre extrémité à la barre preneuse supérieure (3).

2. Dispositif selon la revendication 1, caractérisé en ce que les tiges (21, 22) sont entourées dans la région supérieure par des ressorts (4, 4') qui sont reliés par leurs extrémités supérieures à la barre preneuse supérieure (3) et par leurs extrémités inférieures à des surfaces de fond d'évidements (26, 26') pratiqués dans la barre preneuse inférieure (5).

3. Dispositif selon la revendication 2, caractérisé en ce que les ressorts (4, 4') sont des ressorts de traction qui tirent la barre preneuse supérieure (3) contre la barre preneuse inférieure (5) et en ce qu'en sollicitant en pression les vérins pneumatiques ($C_2$, $C_3$), la barre preneuse supérieure (3) peut être déplacée vers le haut à la po sition ouverte du preneur (12), à l'encontre de la force de traction des ressorts.

4. Dispositif selon la revendication 2, caractérisé en ce que les ressorts (4, 4') sont des ressorts de compression qui éloignent par soulèvement la barre preneuse supérieure (3) de la barre preneuse inférieure (5) et en ce qu'en actionnant les vérins pneumatiques ($C_2$, $C_3$), la barre preneuse supérieure (3) peut être déplacée vers le bas à la position fermée du preneur (12), à l'encontre de la force de compression des ressorts.

5. Dispositif selon la revendication 1, caractérisé en ce que le preneur (12; 13) saisit le support de couche (2) à une distance prédéterminée Xmin du bord avant (23).

6. Dispositif selon la revendication 1, caractérisé en ce que le dispositif preneur (13) possède une seule barre (24) qui est conçue comme barre aspirante.

7. Dispositif selon la revendication 6, caractérisé en ce que la surface aspirante de la barre (24) se situe dans le plan de transport (18) formé par les rouleaux de transport (1) et peut, à une distance prédéterminée Xmin du bord avant (23) du support de couche (2), être soumise à un vide partiel afin d'aspirer le support de couche (2) pour le transporter jusqu'au poste de doublage (16).

8. Dispositif selon la revendication 1, caractérisé en ce qu'un capteur (37), destiné à détecter le bord avant du support de couche (2), est disposé sur une équerre de maintien (28) qui est fixée sur un bloc de maintien (43) mobile dans le sens de transport A du support de couche (2), et en ce que le capteur (37), à la position ouverte du preneur (12), se trouve à une distance réglable Xmin en avant des bords avant des barres preneuses (3, 5) du preneur (12).

9. Dispositif selon la revendication 8, caractérisé en ce qu'un guide linéaire (40) réalise l'assemblage entre le bloc de maintien (43) et l'entretoise (15) qui relie entre eux les montants (19, 20) sur lesquels est fixée la barre preneuse inférieure (5), en ce qu'une partie (42), de position fixée, du guide linéaire (40) est fixée sur le côté inférieur d'une plaque de base (29) qui est assemblée au côté inférieur de l'entretoise (15), et en ce qu'une partie mobile (41) du guide linéaire (40) est fixée sur le bloc de maintien (43).

10. Dispositif selon la revendication 8, caractérisé en ce que les barres preneuses supérieure et inférieure (3, 5) présentent chacune un ajour (38; 39) au milieu de leur partie chanfreinée, en ce que le capteur (37) arrive dans la région de l'ajour (39) de la barre preneuse inférieure (5) lors du déplacement vers l'avant du preneur (12) dans le sens de transport A, et en ce que l'entretoise (15) du preneur s'applique contre l'équerre de maintien (28) munie du capteur (37) et pousse ce dernier vers l'avant en direction du poste de doublage (16) tandis que le déplacement vers l'avant du preneur se poursuit.

11. Dispositif selon la revendication 9, caractérisé en ce qu'une tige de butée (30), parallèle au sens de transport A, est engagée dans un alésage fileté (35) du bloc de maintien (43) et traverse la partie coudée (45) de la plaque de base (29), et en ce qu'une bague de réglage (32) est montée sur la tige de butée (30) à proximité de l'extrémité libre.

12. Dispositif selon la revendication 11, caractérisé en ce que la tige de butée (30) est entourée, entre la bague de réglage (32) et la plaque de base coudée (29), par un ressort (31) qui s'appuie par une extrémité contre le côté extérieur de la partie coudée (45) de la plaque de base (29) et par l'autre extrémité contre la bague de réglage (32).

13. Dispositif selon la revendication 11, caractérisé en ce que l'extrémité libre de la tige de butée (30) s'applique contre une traverse de machine (33), et en ce que la distance entre l'extrémité libre de la tige de butée (30) et le bloc de maintien (43) ou bien la position avant du capteur (37) est allouée de manière fixe.

14. Dispositif selon la revendication 11, caractérisé en ce que l'extrémité libre de la tige de butée (30) s'applique contre une butée (34) qui est vissée dans la traverse de machine (33) et bloquée dans sa position respective par un contre-écrou (36).

15. Dispositif selon les revendications 13 et 14, caractérisé en ce que la distance entre la partie coudée (45) de la plaque de base (29) et la partie mobile (41) du guide linéaire, lorsque la tige de butée (30) est appliquée contre la butée (34) ou bien contre la traverse de machine (33), est supérieure à la distance Xmin.

FIG. 1

FIG.2

13

FIG.3

FIG.4

FIG.5

FIG.6

FIG. 7

FIG. 8